# EUROPEAN PATENT SPECIFICATION

(11) **EP 3 888 783 B1**
(45) Date of publication and mention of the grant of the patent: **26.03.2025**
(21) Application number: 20167573.3
(22) Date of filing: 01.04.2020
(51) Int. Cl.: B01J 19/00, G11C 13/00

(54) **ADDRESSING NANOELECTRODES IN A NANOELECTRODE ARRAY**
ADRESSIERUNG VON NANOELEKTRODEN IN EINEM NANOELEKTRODENARRAY
ADRESSAGE DE NANOÉLECTRODES DANS UN RÉSEAU DE NANOÉLECTRODES

(43) Date of publication of application: 06.10.2021
(73) Proprietor: Imec VZW, 3001 Leuven (BE)
(72) Inventor: HENRY, Olivier, 3001 Leuven (BE); FURNEMONT, Arnaud, 3001 Leuven (BE); COSEMANS, Stefan, 3001 Leuven (BE)
(74) Representative: Winger

(56) References cited:
- US-A1- 2002 029 971
- US-A1- 2006 231 411
- US-A1- 2010 052 080
- US-A1- 2019 326 296

## Description

### Technical field of the invention

The present invention relates to nanoelectrode arrays-for example for use in molecular synthesis-and in particular to addressing the nanoelectrodes therein.

### Background of the invention

The call for cheap and dense cold data storage increasingly raises interest in molecular data storage solutions-such as DNA-based-in which stable organic molecules are synthesized to map binary information. To make such molecular data storage practical, a high synthesis throughput is sought so that a reasonable 'write time' can be achieved. To that end, solutions have been explored in which multiple different molecules are parallelly synthesizing in an array of synthesis cells.

In order to form different molecules in the different synthesis cells, the synthesis must be made selective; i.e. the reaction needs to be enabled in a certain portion of the array and inhibited in the rest of the array. This challenge can be tackled in different ways, but the most promising approaches are based on electrodes. In such approaches, each synthesis cell typically has one or more electrodes associated therewith, with which the reaction conditions (e.g. pH) are locally controlled. US20160354751A1 for example describes a microarray of electrodes for oligonucleotide synthesis having in excess of 12,000 electrodes in a region of about 1 cm², with a circular electrode diameter of about 44 microns and an electrode distance-to-distance of about 75 microns.

However, in order to achieve writing speeds at which the molecular data storage can become commercially relevant, arrays of about one billion electrodes or more would be desired. With a factor in the order of 100,000 compared to US20160354751A1, this represents an aggressive change in scope that brings with it several complications which cannot be overcome in a trivial manner. There is thus still a need in the art for solutions which address at least some of these issues.

US2010052080A1 discloses a biosensor chip for detecting biological particles, the biosensor chip comprising a sensor active region being sensitive for the biological particles and being arranged in a Back End of the Line portion of the biosensor chip. In one embodiments, the biosensor chip may comprise a capacitor structure at least partially formed in the Back End of the Line and arranged such that a capacity value of the capacitor is influencable by a detection event in the sensor active region.

US2002029971A1 discloses a biologic electrode array assembly formed on an integrated circuit chip that includes an array of electrodes for carrying out and controlling multi-step and multiplex reactions in microscopic formats. At least one metal oxide semiconductor (MOS) switch is coupled to at least one of the electrodes within the array. A voltage line is provided that is selectively connected to the at least one electrode via the MOS switch. A voltage source is coupled to the voltage line. In one preferred aspect of the invention, the MOS switch is a CMOS switch. In another aspect of the invention, an addressable memory is associated with the at least one electrode located within the array.

### Summary of the invention

It is an object of the present invention to provide a good system for addressing nanoelectrodes in a nanoelectrode array. It is a further object of the present invention to provide good uses and methods associated with such a system. This objective is accomplished by systems, uses and methods in according to the present invention.

In particular, a convenient way is provided for realizing the aggressive change in scope that was described in the background section. First, at a density of 12,000 electrodes/cm², a straightforward extension of the microarray of US20160354751A1 would require an unwieldy array size of 8.3 m² to reach one billion electrodes. Conversely, the required footprint is presently scaled down considerably through using nanoelectrodes (e.g. having a size of few hundred nanometre or less) rather than microelectrodes with a size of several tens of micrometre. Moreover, it was further realized that a mere size reduction is insufficient. Indeed, perhaps less immediately apparent but at least as important is the issue of how to address roughly one billion or more electrodes sufficiently simultaneously. After all, if the potential for each of these electrodes cannot be set within a relatively short time frame (e.g. compared to the required synthesis time), the synthesis in the synthesis cells will not be parallel and/or the required total write time will be unduly prolonged. This is true for the hypothetical 8.3 m² microarray but is even further exacerbated for an array of nanoelectrodes, where the requirements for the driving electronics (e.g. in terms of available/allowable space, current, power, heat production, etc.) are necessarily increasingly strict. Nevertheless, the present invention offers an elegant solution to this problem; as will be clarified further below.

It is an advantage of embodiments of the present invention that compact (i.e. densely packed) electrode arrays can be formed.

It is an advantage of embodiments of the present invention that a vast number of nanoelectrodes can be individually addressed. It is a further advantage of embodiments of the present invention that the nanoelectrodes can be set relatively simultaneously with respect to the typical time frame needed for a chemical reaction (e.g. the chemical reaction may occur on a time frame in the order of seconds, while all the nanoelectrodes may be set within a time fame in the order of tens of milliseconds). It is yet a further advantage of embodiments of the present invention that the potential for the nanoelectrodes can be quickly set, re-set and/or overwritten.

It is an advantage of embodiments of the present invention that addressing the nanoelectrodes can be performed at low power (e.g. in the order of up to 500 mW) and/or low voltage (e.g. about 0.5 to 1 V in addition to the voltage difference between the lowest and highest potential set for the nanoelectrodes, e.g. between an inactive and an active nanoelectrode or between a counteractive and an active nanoelectrode).

It is an advantage of embodiments of the present invention that the electrode cells have very long (e.g. almost infinite) endurance; i.e. they do not easily break down, even after extended use (e.g. the access transistor can be opened and the storage circuit charged about 10¹⁵ times or more before breaking down).

It is an advantage of embodiments of the present invention that the potential of the nanoelectrodes can be selected and set relatively freely (e.g. the potential is not limited to a discrete number of values). It is a further advantage of embodiments of the present invention that the potential of different nanoelectrodes in the nanoelectrode array can be individually selected and set.

It is an advantage of embodiments of the present invention that well-developed strategies and fabrication methods that have been developed for dynamic random-access memory (DRAM) can be optimally benefited from.

It is an advantage of embodiments of the present invention that the reaction conditions can be physically and/or electrochemically confined.

It is an advantage of embodiments of the present invention that a vast number of different molecules (e.g. DNA) can be synthesized in parallel. It is a further advantage of embodiments of the present invention that an effective DNA data storage can be realized.

It is an advantage of embodiments of the present invention that back end of line (BEOL) electrode cell access transistors can be used, thereby allowing to use the front end of line (FEOL) region entirely for peripheral circuits.

It is an advantage of embodiments of the present invention that-in setting the potential of the nanoelectrodes-also control over their current can be achieved. It is a further advantage of embodiments of the present invention that systems can be realized in which the nanoelectrodes can be operated potentiostatically, galvanostatically or potentiodynamically.

In a first aspect, the present invention relates to a system for addressing nanoelectrodes in a nanoelectrode array, the system comprising an array of electrode cells, each electrode cell comprising: (i) an access transistor having a gate resistively coupled to a word line, a source resistively coupled to a bit line, and a drain; and (ii) a storage circuit resistively coupled to the drain and comprising a nanoelectrode.

In a second aspect, the present invention relates to a use of a system as defined in any embodiment of the first aspect, for addressing nanoelectrodes in a nanoelectrode array.

In a third aspect, the present invention relates to a method for addressing nanoelectrodes in a system according to any embodiment of the first aspect, comprising: (a) selecting a potential for each nanoelectrode, and (b) setting the selected potentials by, for each electrode cell, opening the access transistor by asserting the word line and charging the storage circuit to the selected electrode potential by aptly biasing the bit line.

In a fourth aspect, the present invention relates to a method for synthesizing a molecule, comprising: (a) setting the potential of one or more nanoelectrodes using the method according to any embodiment of the third aspect, and (b) contacting one or more reagents to the nanoelectrodes; thereby locally forming an electrochemical environment for mediating the synthesis.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG 1 and FIG 3 schematically show 3D views of an arrays for molecular synthesis in accordance with embodiments of the present invention.
FIG 2 and FIG 4 schematically shows more detailed vertical cross-sections of the arrays in FIG 1 and FIG 3.
FIG 5, FIG 6 and FIG 7 schematically show a top view of several nanoelectrodes, illustrating embodiments of the present invention in which the reaction conditions are electrochemically confined.
FIG 8 schematically depicts an array of electrode cells in accordance with embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable with their antonyms under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled" should not be interpreted as being restricted to direct connections only. The terms "coupled" and "connected", along with their derivatives, may be used. It should be understood that these terms are not intended as synonyms for each other. Thus, the scope of the expression "an entity A coupled to an entity B" should not be limited to situations wherein an output of entity A is directly connected to an input of entity B. It means that there exists a path between an output of A and an input of B, which may be a path including other entities or means. "Coupled" may thus mean that two or more elements are either in direct contact (i.e. they may be connected), or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practised without these specific details. In other instances, well-known methods, structures and techniques have not been shown in detail in order not to obscure an understanding of this description.

Reference will be made to transistors. These are devices having a first main terminal (e.g. a source or collector), a second main terminal (e.g. a drain or emitter) and a control terminal (e.g. a gate or base) for controlling the flow of electrical charges between the first and second main terminals.

For a better qualitative understanding, an analogy with dynamic random-access memory (DRAM) and its operation will herein occasionally be made. It shall be clear however that the field of DRAM is hereto not a neighbouring field to nanoelectrode arrays and that they are concerned with different technical problems. As such, it shall be clear that this *ex post facto* analogy-which is given here only to aid the reader's understanding-should not be abused to diminish the inventive step of the present invention. Indeed, the realization-to our knowledge for the first time and without direction thereto in the prior art-that circuits which are well known in DRAM can-with the required adaptations-be repurposed to solve a technical problem faced in nanoelectrode arrays, forms an appreciable part of the inventive effort achieved by the present inventors.

In a first aspect, the present invention relates to a system for addressing nanoelectrodes in (e.g. arranged as) a nanoelectrode array, the system comprising an array of electrode cells, each electrode cell comprising: (i) an access transistor having a gate resistively coupled to a word line, a source resistively coupled to a bit line, and a drain; and (ii) a storage circuit resistively coupled to the drain and comprising a nanoelectrode.

It was surprisingly conceived within the present invention that addressing of nanoelectrodes in a nanoelectrode array can be realized in an effective manner by resistively coupling each nanoelectrode-as part of a storage circuit-to the drain of an access transistor. Here, the analogy can be made with DRAM: the present electrode cell can be likened to a DRAM memory cell having a nanoelectrode coupled to the storage side thereof. Based on such an electrode cell, the potential of the nanoelectrodes can then be set using similar strategies (cf. infra) as have been developed to write to DRAM memory cells, including-optionally-periodically refreshing the set potentials.

In embodiments, the array of electrode cells may comprise one or more rows, the electrode cells in a row being linked by a common word line, and/or one or more columns, the electrode cells in a column being linked by a common bit line. In embodiments, the electrode cells may be arranged in a cubic packing, hexagonal packing or any other suitable arrangement.

In embodiments, the storage circuit may comprise the nanoelectrode and an electrical connection (e.g. wire) resistively coupling the nanoelectrode to the drain. In embodiments, the storage circuit may further comprise a capacitor. In embodiments, the capacitor may have a terminal resistively coupled to both the drain and the nanoelectrode (i.e. the same terminal may be coupled to both). In some embodiments, the capacitor may be a separate (i.e. distinct) capacitor; i.e. the capacitor may be an electrical component solely dedicated to that role. In other-alternative or complementary-embodiments, an electrical component may perform the role of capacitor and one or more further functions. For example, a capacitor may be formed about the electrical connection coupling the drain to the nanoelectrode, so that the ensemble simultaneously fulfils the role of the electrical connection and capacitor. Such a capacitor could for instance be achieved by wrapping the electrical connection with a dielectric and then wrapping a counter-electrode about dielectric. In yet other-alternative or complementary-embodiments, through their inherent parasitic capacitance (e.g. wire capacitance), the storage circuit and/or the electrical connection as such may be regarded as a capacitor.

In embodiments, the storage circuit may have a capacitance of at least 0.01 fF, preferably at least 1 fF, more preferably at least 10 fF, yet more preferably at least 20 fF, such as at least 30, 50, 100, 200 or 500 fF. Especially in combination with a suitable refresh rate (e.g. 64 ms or more; cf. infra), such a capacitance-in particular in the order of 10 fF (e.g. about 30 fF) or more-should typically allow to store enough charge in order to drive an electrochemical reaction for a sufficient period of time (e.g. until the next refresh) to for instance enable or disable a synthesis reaction within a synthesis cell above the nanoelectrode. In embodiments, the capacitance of the storage circuit may be partially or entirely due to a parasitic capacitance (e.g. wire capacitance) of the storage circuit. In embodiments, the capacitor may have a capacitance of at least 0.01 fF, preferably at least 1 fF, more preferably at least 10 fF, yet more preferably at least 25 fF, most preferably at least 30 fF, such as at least 30, 50, 100, 200 or 500 fF. Note that there is also a practical upper limit to the capacitance in that charging the storage circuit takes longer when the capacitance thereof is higher. As such, a favourable range for the capacitance may be from about 20 to about 500 fF when using a front-end-of-line (FEOL) access transistors, and from about 1 to 25 fF when using a back-end-of-line (BEOL; cf. infra) transistor.

In embodiments, the nanoelectrode may have a size (e.g. a width or diameter) of 1 µm or less, preferably 500 nm or less, more preferably 250 nm or less, yet more preferably 150 nm or less, such as 100 nm or less. In embodiments, the nanoelectrodes (e.g. the nanoelectrode array) may have a pitch (i.e. a centre-to-centre distance between adjacent nanoelectrodes) of 1 µm or less, preferably 500 nm or less, more preferably 250 nm or less, yet more preferably 150 nm or less, such as 100 nm or less. The currently most advanced DRAM nodes for example use a hexagonal lay-out (e.g. of the capacitors) with a pitch of about 30 nm, illustrating that the aforementioned dimensions are well within the current technological capabilities.

In embodiments, the access transistors-and optionally the electrode cells as a whole-may be formed on a semiconductor substrate (e.g. a Si, Ge, SiGe or semiconductor-on-insulator substrate). In embodiments, the access transistor may be a planar transistor (e.g. a planar field-effect transistor, planar FET) or a vertical transistor (e.g. a vertical FET, VFET). In embodiments, the access transistor may be a back end of line (BEOL) transistor; i.e. a transistor formed during the BEOL stage of semiconductor processing. The access transistor may for example be a thin film metal-oxide-semiconductor FET (MOSFET), such as based on an indium gallium zinc oxide (IGZO), polysilicon, 2D material (e.g. MoS₂, MoSe₂, MoTe₂, WS₂ or WSe₂) thin film. The use of BEOL access transistors advantageously allows to dedicate the front end of line (FEOL) region below the electrode cell array for peripheral circuits (e.g. write drivers, refresh circuits and/or data transfers).

In embodiments, the array of electrode cells may count 30,000 electrode cells or more, preferably 100,000 or more, more preferably 250,000 or more, yet more preferably 1,000,000 or more, most preferably 10,000,000 or more, such as up to 16,000,000 or more. In embodiments, the array may have a size (e.g. a block size) in the order of 256 (e.g. along the wordline direction) by 128 (e.g. along the bitline direction) or more, preferably 1,024 by 256 or more, more preferably 16,384 by 1,024 or more. In embodiments, the system may comprise a plurality of electrode cell arrays. By having multiple electrode cell arrays which can be written simultaneously (i.e. akin to sub-banking in DRAM), the throughput at low energy can advantageously be improved. In embodiments, the system may count a total of 30,000 electrode cells or more, preferably 100,000 electrode cells or more, more preferably 1,000,000 or more, yet more preferably 10,000,000 or more, still yet more preferably 100,000,000 or more, most preferably 1,000,000,000 or more, such as up to 1,000,000,000,000 or more.

In embodiments, any feature of any embodiment of the first aspect may independently be as correspondingly described for any embodiment of any of the other aspects.

In a second aspect, the present invention relates to a use of a system as defined in any embodiment of the first aspect, for addressing nanoelectrodes in a nanoelectrode array.

In embodiments, the use may be for operating at least one of the nanoelectrodes potentiostatically, galvanostatically or galvanodynamically (cf. infra). In embodiments, the use may be for operating at least one of the nanoelectrodes potentiostatically, galvanostatically or galvanodynamically within a predetermined margin. Thus, the nanoelectrode may-within the predetermined margin (i.e. plus or minus the margin)-respectively be maintained at a constant potential, maintained at a constant current or its potential may be swept at a constant rate. The predetermined margin may be 30% or less, preferably 20% or less, more preferably 10%, yet more preferably 5% or less, most preferably 2% or less, such as 1% or less.

In embodiments, any feature of any embodiment of the second aspect may independently be as correspondingly described for any embodiment of any of the other aspects.

In a third aspect, the present invention relates to a method for addressing nanoelectrodes in a system according to any embodiment of the first aspect, comprising: (a) selecting a potential for each nanoelectrode, and (b) setting the selected potentials by, for each electrode cell, opening the access transistor by asserting the word line and charging the storage circuit to the selected electrode potential by aptly biasing the bit line.

In embodiments, step b may further comprise closing the access transistor after having charged the storage circuit. In embodiments, the access transistor may be closed before opening a further access transistor.

In embodiments, step b may comprise charging the storage circuit to the selected electrode potential by biasing the bit line to a potential (e.g. with respect to ground) of from -3 to 3 V, preferably from -2 to 2 V, such as from -1 to 1 V. In embodiments, the potential selected in step a and set in step b may differ for different nanoelectrode. The potential that can be selected and set is advantageously not limited to a discrete set of values (e.g. such as in a digital case), but can be essentially any of a continuous set of values (within the margins of experimental accuracy). This advantageously allows to select the potential based on the specific requirements for each nanoelectrode. For example, as a DNA strand is further expanded (cf. Example 4) away from the nanoelectrode, the generated H⁺ concentration may need to rise in order to achieve the same deprotection efficiency on the further away protection group. As such, the degree to which the storage circuit is charged may need to be raised in function of the length of the DNA strand. Moreover, different DNA strands across the array may have a different length, so that the optimal stored charge may differ from one storage circuit to the next. Moreover, the ideal potential for a nanoelectrode may depend on the state of the neighbouring cells. Such needs can advantageously be accommodated to within the present invention through changing the biasing potential and/or charging time used.

In embodiments, step b may comprise setting a plurality of the selected electrode potentials simultaneously by-for a row of electrode cells linked by a common word line-opening all access transistors by asserting the common word line and-for each electrode cell in the row-charging the storage circuit by aptly biasing the bit line. In embodiments, step b may further comprise closing all the access transistors in the row after having charged the storage circuits. In embodiments, the access transistors in the row may be closed before opening a further row of access transistors. Strategies akin to those that have been used to quickly write to a vast number of memory cells in DRAM can advantageously be used in the present invention to quickly (e.g. virtually simultaneously compared to the time frame of the chemical reactions that are being considered) address a large number of nanoelectrodes.

After having charged the storage circuit, the stored charge can be used to drive the nanoelectrode, e.g. to perform an electrochemical reaction. In doing so, the stored charge will typically be used over time. Moreover, even if not expended to drive an electrochemical reaction, the stored charge will typically (slowly; e.g. in the order of milliseconds) leak out of the storage circuit (e.g. through the reaction medium, transistor or capacitor) and thus anyway deplete overtime. Thus, after the storage circuit has been charged, the nanoelectrode will typically experience a potential profile which decays over time.

In embodiments, the method may comprise a further step c of: (c) refreshing the selected potentials by repeating step b. In embodiments, step c may comprise repeating step b periodically, such as periodically for a predetermined duration (e.g. for a duration needed to complete a chemical reaction). Refreshing the selected potentials advantageously allows to recover the decaying potential profile. In doing so, the experienced potential profile can be turned into a periodic function. Depending on the interplay between the characteristics of the storage circuit (e.g. its capacitance), the retention time/decay rate (as affected by actively using up the stored charge or through inevitable depletion) and the refresh rate (i.e. the duration between the start times of subsequent repetitions of step b) the amplitude of the periodic function can be made larger (e.g. corresponding to more pronounced potential pulses) or smaller (e.g. corresponding to an overall flatter potential profile). In embodiments, the refresh rate may from 5 to 500 ms, preferably from 20 to 250 ms, more preferably from 35 to 150 ms, yet more preferably from 40 to 100 ms, most preferably from 55 to 75 ms, such as 64 ms. The typical refresh rate for DRAM memory is for example 64 ms, so current refresh circuits are advantageously already adapted to such a refresh rate.

In step a, the potential for each nanoelectrode may typically be selected in function of the goal that is to be achieved for that nanoelectrode. This goal may for example include whether the nanoelectrode is to be set active, neutral or counteractive (cf. infra); but it can also include how the nanoelectrode is to be controlled, for example potentiostatically (i.e. aiming to maintain the nanoelectrode at a constant potential), galvanostatically (i.e. aiming to maintain the nanoelectrode at a constant current) or potentiodynamically (e.g. aiming to sweep the nanoelectrode's potential at a constant rate). Operating the nanoelectrode at a constant potential -within a predetermined margin (cf. supra)-can for example be achieved by refreshing the set potential before it has decayed (cf. supra) below this margin. Operating the nanoelectrode at a constant current-again within a predetermined margin-may be achieved using a comparable strategy, through an adaptive refresh. Here it may not suffice to simply set the potential back to the previously set value, but rather the storage circuit should be charged in function of the charge that has been expended since the previous set action; meaning that the potential to be set may need to be adapted for each refresh. This can for example be achieved by first reading out the remaining charge (remaining potential) through the bit line at the start of the refresh and determining therefrom the new potential that is to be set in order to maintain a (relatively) constant current. Another strategy to operate the nanoelectrode at a constant current within a predetermined margin is to make use of capacitive charge injection through the capacitor (if present), by connecting the capacitor's second terminal to an inject line. In that case, a linear voltage ramp on the inject line will for example result in a fixed charge influx into the storage circuit. For nanoelectrodes set to active (e.g. set to a high potential),-depending on the specific parameters chosen-a balance between incoming and outgoing charge can be achieved, resulting in a relatively constant current. For nanoelectrodes set to inactive (e.g. set to a low potential), the incoming charge will charge the storage circuit, but as long as the potential thereby developed is lower than needed to drive the reaction, this reaction will not be enabled. During a refresh, this built-up charge can then again be released through the word line, so that the inactive nanoelectrodes can be kept inactive by using a suitable refresh rate. In embodiments, these strategies for maintaining a (relatively) constant current can also advantageously be combined.

In embodiments, step b may comprise setting the nanoelectrode to be active, neutral or counteractive. 'Active', 'neutral' and 'counteractive' here refer to the electrochemical activity of the nanoelectrode: an active electrode has a suitable potential for bringing about a particular electrochemical reaction, a counteractive electrode has a suitable potential for bringing about a different reaction (e.g. the opposite reaction, in so far as the electrochemical reaction is reversible) and an inactive electrode has an intermediate potential which is neither sufficient to bring about the particular electrochemical reaction nor its opposite. In embodiments, step a may comprise selecting more negative potentials for the nanoelectrodes which are to be active, and intermediate potentials for the nanoelectrodes which are to be inactive and/or more positive potentials for the nanoelectrodes which are to be counteractive. In other embodiments, step a may comprise selecting more positive potentials for the nanoelectrodes which are to be active, and intermediate potentials for the nanoelectrodes which are to be inactive and/or more negative potentials for the nanoelectrodes which are to be counteractive. In the above, rather than referring to absolute values, the potentials are expressed relative to one another. Indeed, the specific potential values will i.a. typically depend on the reference point that is selected (e.g. ground or a counter-electrode contacting the reaction medium). As such, a 'more negative' potential may in some instances still be positive, etc. Regardless of the reference point selected however, suitable potentials for setting a nanoelectrode to active, inactive or counteractive for a particular electrochemical reaction can typically be calculated (e.g. based theory and modelling) or can be derived by relatively simple and straightforward trial-and-error.

In embodiments, any feature of any embodiment of the third aspect may independently be as correspondingly described for any embodiment of any of the other aspects.

In a fourth aspect, the present invention relates to a method for synthesizing a molecule, comprising: (a) setting the potential of one or more nanoelectrodes using the method according to any embodiment of the third aspect, and (b) contacting one or more reagents to the nanoelectrodes; thereby locally generating reaction conditions for mediating the synthesis.

Synthesizing the molecule may typically be performed in a reaction medium; such as a fluid (e.g. a liquid or gas). In embodiments, the reaction medium may contact the nanoelectrodes. In embodiments, the reaction medium may comprise the one or more reagents. In embodiments, the method may further comprise contacting a counter-electrode to the reaction medium.

In embodiments, the molecule to be synthesized may be a molecule, such as a biomolecule; e.g. a biopolymer such as (synthetic) DNA. In embodiments, the method may be for forming a DNA data storage (i.e. a data storage system in which data is encoded in DNA) or for spatial transcriptomics, preferably DNA data storage.

In embodiments, the step b may be started before, together with or after starting step a. In embodiments, step a and step b may at least partially overlap in time. In other words, regardless of which step is performed first, the nanoelectrodes are most commonly (still) at a certain potential when the reagents are (still) in contact with the nanoelectrodes.

In embodiments, mediating the synthesis may comprise locally enabling or disabling the synthesis. In embodiments, mediating the synthesis may comprise directly or indirectly mediating the synthesis. Most often, at least one of the contacted reagents may directly interact-undergo an electrochemical oxidation or reduction-with charges of an (active or counteractive) nanoelectrode, thereby yielding a change in reaction conditions (e.g. a change in the concentration of an active species, such as an electrochemical reagent or reaction product). Here, 'direct interaction with charges of the nanoelectrode' may comprise interaction at the nanoelectrode surface as such or-away from said surface-with charges having migrated through the reaction medium. Regardless, based on the altered reaction conditions, one or more further chemical reactions-e.g. involving the reagents or reaction products of the first reaction and/or one or more further reagents-may then be enabled or disabled. Such further reagents may be added together with the initial electrochemically active reagent or may added at a later stage. To name but one example of indirect mediation, the generated reaction conditions (e.g. a lowered pH) may lead to deprotection of a reagent (e.g. a DNA strand) by removal of a protective group and then in turn further enable a synthetic reaction between the deprotected reagent (e.g. DNA synthesis) and one or more further reagents (e.g. a nucleotide).

In embodiments, the generated reaction conditions in step b may comprise a change in pH (e.g. by generating protons through the oxidation of hydroquinone or consumption of protons through the reduction of benzoquinone), generation of free radicals (e.g. by an electrochemically produced from persulfates), the generation of Cu-ions (e.g. for click chemistry) or the generation of divalent cations (e.g. to control an enzymatic reaction).

In embodiments, the method may further comprise a step c of: (c) withdrawing (e.g. washing away) one or more of the reagents. In embodiments, the method may comprise repeating a sequence of steps a, b and-optionally-c. In embodiments, the sequence of steps may be repeated an arbitrary number of times (cf. Example 4).

In embodiments, any feature of any embodiment of the fourth aspect may independently be as correspondingly described for any embodiment of any of the other aspects.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

### Example 1: Array with physical confinement of the reaction conditions

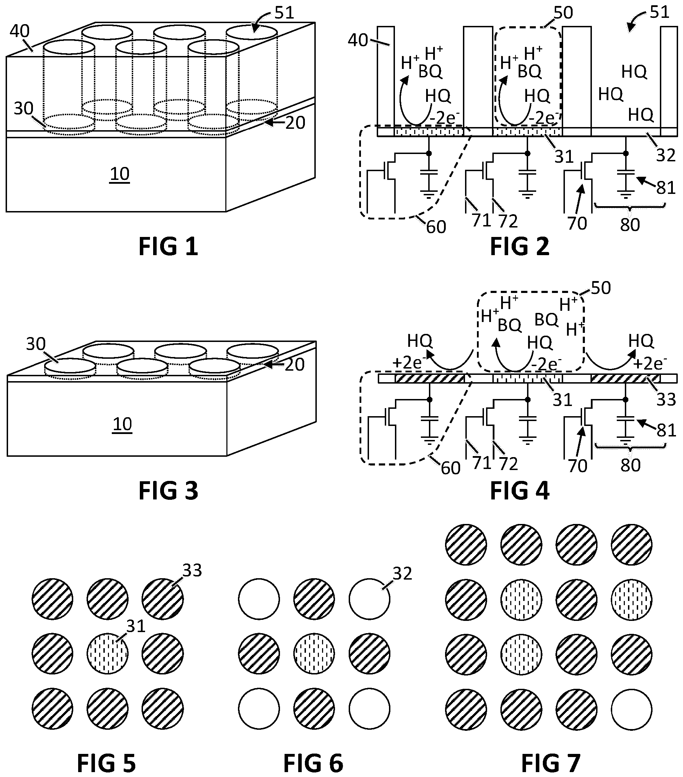

We now refer to FIG 1, depicting a 3D view of an array for molecular synthesis in which the reaction conditions are confined by physical means. To that end, the array comprises a nanoelectrode array (20) on a substrate (10) and a perforated cover layer (40) over the nanoelectrode array (20). The perforated cover layer (40) comprises cavities (51) which overlay and open up the nanoelectrodes (30) at the bottom thereof. As such, each cavity (51) forms a synthesis cell (50) in which the walls that define it hinder diffusion of the reaction medium from one synthesis cell (50) to the next, thereby locally confining the reaction medium-and thus the reaction conditions. One or more counter electrodes (not depicted), for example arranged in a counter electrode array, are also typically present. These may for example be situated above the nanoelectrode array (20) (e.g. atop the perforated cover layer (40) or further above)-in which case they may e.g. be parallel with nanoelectrodes (30)-or coplanar with the electrode array (20). Each nanoelectrode (30) is then typically associated with a counter electrodealthough it is not excluded that one counter electrode may be associated with a plurality of nanoelectrodes (30)-and the electric potential difference developed between both of these governs the electrochemical reaction in the synthesis cell (50)

This is also illustrated in FIG 2, where two active nanoelectrodes (31) are shown to electrochemically oxidize hydroquinone (HQ) to benzoquinone (BQ), thereby producing protons (H⁺) and locally lowering the pH. Migration of the protons and other reaction products outside the synthesis cell (50) in which they are formed is however hindered by the walls of the perforated cover layer (40), so that they remain localized to the synthesis cell (50). Accordingly, a change in pH is not observed in the right-most synthesis cell (51), where the corresponding nanoelectrode (32) is inactive. This allows to control-through setting the nanoelectrode (31, 32)-the reaction conditions (e.g. pH) in each synthesis cell (50) individually, thereby across the array managing where a reaction is enabled and where it is disabled.

FIG 2 also shows more details of the electrode cells (60) with which the nanoelectrodes (31, 32) are addressed. Each electrode cell (60) comprises a storage circuit (80)-with the corresponding nanoelectrode (31, 32)-and an access transistor (70)-with a gate, a source and a drain. Each nanoelectrode (31, 32) is then addressable through controlling the corresponding access transistor (70) in its electrode cell (60). More in particular, the potential of each nanoelectrode (31, 32) can be individually set by asserting the corresponding word line (71) to open the access transistor (70) and biasing the corresponding bit line (72) to charge the storage circuit (80). After disconnecting the access transistor (70), the charge stored the storage circuit (80) can then be ('slowly') used by the nanoelectrode (31, 32), e.g. to drive an electrochemical reaction. Moreover, even if not expended to drive an electrochemical reaction, slow-e.g. in the order of (tens of) milliseconds-depletion of the stored charge will typically occur; e.g. because of unavoidable leaks (cf. supra). Since the reaction time may typically be in the order of a fraction of a second to several seconds, the duration over which one may wish to maintain the potential will typically be longer than the retention/depletion time of the storage circuit (80). To remedy this, the nanoelectrodes (31, 32) can be periodically rewritten (i.e. re-set or recharged), thereby extending their duration (see also Example 3).

The storage circuit (80) depicted in FIG 2 comprises a capacitor (81) of which one terminal is resistively coupled to both the drain and the nanoelectrode (31, 32). However, a separate capacitor (81) isn't strictly required and a sufficient storage capacitance in the storage circuit (80) could be achieved based on parasitic capacitance (e.g. wire capacitance) of the storage circuit (80) as such and/or a capacitor (81) formed about the electrical connection coupling the drain to the nanoelectrode (31, 32).

### Example 2: Array with electrochemical confinement of the reaction conditions

FIG 3 depicts a similar 3D view as FIG 1, but for an array in which confinement is achieved electrochemically. The array shown in FIG 3 differs from the one in FIG 1 in that it doesn't comprise the perforated cover layer (40). Instead, as illustrated in FIG 4, confinement is achieved by setting the nanoelectrodes (33) surrounding the active nanoelectrodes (31) to be counteractive, so that the opposite reaction occurs there. In the example shown in FIG 4, protons are generated by oxidizing hydroquinone to benzoquinone at the active nanoelectrode (31) and are consumed near the counteractive nanoelectrodes (33) in the reduction of benzoquinone back to hydroquinone. Thus, as the produced protons start to diffuse away from the active nanoelectrodes (31), they are consumed at the surrounding counteractive nanoelectrodes (33), thereby-even in the absence of physical boundaries-still confining the reaction conditions to the desired synthesis cells (50).

Surrounding of active nanoelectrodes (31) by counteractive nanoelectrodes (33) in a cubically packed array is also illustrated in the top views of FIG 5, FIG 6 and FIG 7.

FIG 5 shows a single active nanoelectrode (31) surrounded by eight counteractive nanoelectrodes (33). However, as shown in FIG 6, it may in embodiments be sufficient to set only the four immediately closest nanoelectrodes (33) to counteractive and to have the further nanoelectrodes (32) kept inactive. FIG 7 illustrates a further situation in which two neighbouring nanoelectrodes (31) are set to be active, the nanoelectrodes (33) surrounding the active nanoelectrodes (31) are set to be counteractive and the nanoelectrode (32) which is not active and not next to an active nanoelectrode (31) are set to be inactive.

The above notwithstanding, it will be clear that the cubic packing shown here is only illustrative and that other arrangements (e.g. a hexagonal packing) of the array can likewise envisioned.

### Example 3: Array of electrode cells

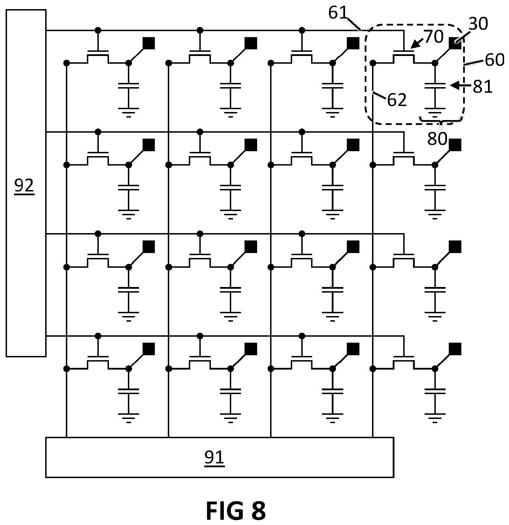

We now refer to FIG 8, which schematically depicts an array of electrode cells (60), each electrode cell (60) comprising a storage circuit (80)-with a corresponding nanoelectrode (30)-and an access transistor (70). The electrode cells (60) are arranged in rows and columns, wherein the electrode cells (60) in a row are linked by a common word line (71) and in a column by a common bit line (72). The word lines (71) are coupled to a row address selector (91), while the bit lines (72) are coupled to a column address selector (92). Note however that the electrode cell array is again not limited to a cubic packing and that other arrangements (e.g. hexagonal packing) can likewise envisioned.

Akin to the operation of DRAM memory, setting the potential of the nanoelectrodes (30) may be performed through opening all access transistors (70) in a row by asserting the common word line (71) and, for each electrode cell (60) in the row, charging the storage circuit (80) by correspondingly biasing the associated bit line (72).

In order to maintain the potential for an extended duration (e.g. several seconds), the nanoelectrodes (30) can be periodically rewritten (i.e. re-set or recharged); not unlike a periodic memory refresh in DRAM. Note however that in the present invention, the stored charge in the storage circuit (80) will typically be used up (e.g. in electrochemical reactions) or will otherwise dissipate (e.g. through the reaction medium) over time. As such, contrary to a DRAM refresh, it may not be possible to read the potential to be set back out prior to rewriting it and that information may need to be retrieved or maintained elsewhere (e.g. the selected potential for each nanoelectrode may need to be stored separately for as long as this information is still needed).

Likewise, other strategies used to improve the operation of DRAM memory can also be used in the context of the present invention. For example, the system may comprise multiple arrays in a sub-banked arrangement, so that the arrays can be (re)written at the same time, thereby improving the throughput at low energy.

### Example 4: Using a system in accordance with the present invention in biological synthesis

An array such as for example described in Example 1 and Example 2, may for instance be used in the synthesis of (synthetic) DNA or another (bio)molecule. A method for expanding one or more protected DNA strands may for example start with providing the protected DNA strand(s) in the synthesis cells over the nanoelectrodes (e.g. one strand per synthesis cell). Next, one or more reagents for-in combination with an active nanoelectrode-deprotecting the DNA strands may be provided in the reaction medium (e.g. a proton-generation agent, such hydroquinone, for the acid-based deprotection). A number of nanoelectrodes where a particular nucleotide is to be added can then be selected and the nanoelectrodes in the nanoelectrode array can be set accordingly (e.g. the corresponding nanoelectrodes can be activated and-e.g. in an array such as described in Example 2-the surrounding nanoelectrodes can be set to be counteractive). By doing so, the deprotection reaction is locally enabled and specifically the selected DNA strands can be deprotected, while leaving the other DNA strands protected. A derivative of the nucleotide-e.g. bearing a further protective group-can then be brought into the reaction medium and be reacted with the deprotected strands, resulting in selectively expanded strands which again bear a protective group. After washing away the nucleotide derivative, the procedure can be restarted-e.g. in order to add another nucleotide to the DNA strand(s)-and it can be repeated an arbitrary number of times to yield DNA strands with an arbitrary sequence. Note in particular that, since the strands to be expanded can be selected in every instance of the procedure, the sequence of DNA strands need not be the same. Indeed, the DNA strand above each nanoelectrode may have a unique sequence. As such, the array can be used to make a DNA data storage.

It is to be understood that although preferred embodiments, specific constructions and configurations, as well as materials, have been discussed herein for devices according to the present invention, various changes or modifications in form and detail may be made without departing from the scope and technical teachings of this invention. For example, any formulas given above are merely representative of procedures that may be used. Functionality may be added or deleted from the block diagrams and operations may be interchanged among functional blocks. Steps may be added or deleted to methods described within the scope of the present invention as defined by the appended claims.

## Claims

1. A system for addressing electrodes (30-33) in an electrode array (20) for synthesizing a molecule, the system comprising an array of electrode cells, each electrode cell (60) comprising:
i. an access transistor (70) having
- a gate,
- a source, and
- a drain; and
ii. a storage circuit (80);
**characterized in that**
- the electrodes are nanoelectrodes,
- the electrode array is a nanoelectrode array,
- the gate is resistively coupled to a word line (71),
- the source is resistively coupled to a bit line (72), and
- the storage circuit (80) is resistively coupled to the drain and comprises a nanoelectrode (30-33).

2. The system according to claim 1, wherein the array of electrode cells (60) comprises
- one or more rows, the electrode cells (60) in a row being linked by a common word line (71), and/or
- one or more columns, the electrode cells (60) in a column being linked by a common bit line (72).

3. The system according to any of the previous claims, wherein the storage circuit (80) comprises the nanoelectrode (30-33) and an electrical connection resistively coupling the nanoelectrode (30-33) to the drain.

4. The system according to any of the previous claims, wherein the storage circuit (80) further comprises a capacitor (81).

5. The system according to claim 4, wherein the capacitor (81) has a terminal resistively coupled to both the drain and the nanoelectrode (30-33).

6. The system according to any of the previous claims, wherein the storage circuit (80) has a capacitance of at least 0.01 fF, preferably at least 1 fF, more preferably at least 10 fF, yet more preferably at least 25 fF.

7. The system according to any of the previous claims, wherein the array of electrode cells counts 30,000 electrode cells (60) or more, preferably 100,000 or more, more preferably 250,000 or more, yet more preferably 1,000,000 or more, most preferably 10,000,000 or more.

8. The system according to any of the previous claims, wherein the access transistor is a back end of line (BEOL) transistor.

9. The system according to any of the previous claims, wherein the nanoelectrodes have a pitch of 1 µm or less, preferably 500 nm or less, more preferably 250 nm or less, yet more preferably 150 nm or less.

10. Use of a system as defined in any of the previous claims, for addressing nanoelectrodes (30-33) in a nanoelectrode array (20).

11. A method for addressing nanoelectrodes (30-33) in a system as defined in any of claims 1 to 8, comprising:
a. selecting a potential for each nanoelectrode (30-33), and
b. setting the selected potentials by, for each electrode cell (60),
- opening the access transistor (70) by asserting the word line (71) and
- charging the storage circuit (80) to the selected electrode potential by aptly biasing the bit line (72).

12. The method according to claim 11, wherein step b comprises setting a plurality of the selected electrode potentials simultaneously by,
- for a row of electrode cells (60) linked by a common word line (71), opening all access transistors (70) by asserting the common word line (71) and,
- for each electrode cell (60) in the row, charging the storage circuit (80) by aptly biasing the bit line (72).

13. The method according to any of claims 11 to 12, comprising a further step c of:
c. refreshing the selected potentials by repeating step b.

14. A method for synthesizing a molecule, comprising:
a. setting the potential of one or more nanoelectrodes (30-33) using the method according to any of claims 11 to 13, and
b. contacting one or more reagents to the nanoelectrodes (30-33); thereby locally generating reaction conditions for mediating the synthesis.

15. The method according to claim 14, for forming a DNA data storage.

## Patentansprüche

1. Ein System zum Adressieren von Elektroden (30-33) in einer Elektrodenanordnung (20) zum Synthetisieren eines Moleküls, wobei das System eine Anordnung von Elektrodenzellen umfasst, wobei jede Elektrodenzelle (60) umfasst:
i.- einen Zugriffstransistor (70), der aufweist
- ein Gate,
- eine Source, und
- einen Drain; und
ii.- eine Speicherschaltung (80);
**dadurch gekennzeichnet, dass**
- die Elektroden Nanoelektroden sind,
- die Elektrodenanordnung eine Nanoelektrodenanordnung ist,
- das Gate resistiv mit einer Wortleitung (71) gekoppelt ist,
- die Source resistiv mit einer Bitleitung (72) gekoppelt ist, und
- die Speicherschaltung (80) resistiv mit dem Drain gekoppelt ist und eine Nanoelektrode (30-33) umfasst.

2. Das System nach Anspruch 1, wobei die Anordnung von Elektrodenzellen (60) umfasst
- eine oder mehrere Zeilen, wobei die Elektrodenzellen (60) in einer Zeile durch eine gemeinsame Wortleitung (71) verbunden sind, und/oder
- eine oder mehrere Spalten, wobei die Elektrodenzellen (60) in einer Spalte durch eine gemeinsame Bitleitung (72) verbunden sind.

3. Das System nach einem der vorstehenden Ansprüche, wobei die Speicherschaltung (80) die Nanoelektrode (30-33) und eine elektrische Verbindung umfasst, die die Nanoelektrode (30-33) resistiv mit dem Drain koppelt.

4. Das System nach einem der vorstehenden Ansprüche, wobei die Speicherschaltung (80) weiter einen Kondensator (81) umfasst.

5. Das System nach Anspruch 4, wobei der Kondensator (81) einen Anschluss aufweist, der sowohl mit dem Drain als auch mit der Nanoelektrode (30-33) resistiv gekoppelt ist.

6. Das System nach einem der vorstehenden Ansprüche, wobei die Speicherschaltung (80) eine Kapazität von mindestens 0,01 fF, bevorzugt mindestens 1 fF, bevorzugter mindestens 10 fF, noch bevorzugter mindestens 25 fF aufweist.

7. Das System nach einem der vorstehenden Ansprüche, wobei die Anordnung von Elektrodenzellen 30.000 Elektrodenzellen (60) oder mehr, bevorzugt 100.000 oder mehr, bevorzugter 250.000 oder mehr, noch bevorzugter 1.000.000 oder mehr, besonders bevorzugt 10.000.000 oder mehr, zählt.

8. Das System nach einem der vorstehenden Ansprüche, wobei der Zugriffstransistor ein Back-End-of-Line- (BEOL-) Transistor ist.

9. Das System nach einem der vorstehenden Ansprüche, wobei die Nanoelektroden eine Teilung von 1 µm oder weniger, bevorzugt 500 nm oder weniger, bevorzugter 250 nm oder weniger, noch bevorzugter 150 nm oder weniger, aufweisen.

10. Verwendung eines Systems wie in einem der vorstehenden Ansprüche definiert zum Adressieren von Nanoelektroden (30-33) in einer Nanoelektrodenanordnung (20).

11. Ein Verfahren zum Adressieren von Nanoelektroden (30-33) in einem System wie in einem der Ansprüche 1 bis 8 definiert, umfassend:
a.- Auswählen eines Potentials für jede Nanoelektrode (30-33), und
b.- Einstellen der ausgewählten Potentiale durch, für jede Elektrodenzelle (60),
- Öffnen des Zugriffstransistors (70) durch Inanspruchnehmen der Wortleitung (71), und
- Laden der Speicherschaltung (80) auf das ausgewählte Elektrodenpotential durch passendes Vorspannen der Bitleitung (72).

12. Das Verfahren nach Anspruch 11, wobei Schritt b das gleichzeitige Einstellen einer Vielzahl der ausgewählten Elektrodenpotentiale umfasst durch
- für eine Zeile von Elektrodenzellen (60), die über eine gemeinsame Wortleitung (71) verbunden sind, Öffnen aller Zugriffstransistoren (70) durch Inanspruchnehmen der gemeinsamen Wortleitung (71), und
- für jede Elektrodenzelle (60) in der Zeile, Laden der Speicherschaltung (80) durch passendes Vorspannen der Bitleitung (72).

13. Das Verfahren nach einem der Ansprüche 11 bis 12, das einen weiteren Schritt c umfasst:
c.- Aktualisieren der ausgewählten Potentiale durch Wiederholen von Schritt b.

14. Ein Verfahren zum Synthetisieren eines Moleküls, umfassend:
a.- Einstellen des Potentials einer oder mehrerer Nanoelektroden (30-33) unter Verwendung des Verfahrens nach einem der Ansprüche 11 bis 13, und
b.- Inkontaktbringen eines oder mehrerer Reagenzien mit den Nanoelektroden (30-33);
dadurch lokales Erzeugen von Reaktionsbedingungen zum Vermitteln der Synthese.

15. Das Verfahren nach Anspruch 14 zum Bilden eines DNA-Datenspeichers.

## Revendications

1. Un système pour adresser des électrodes (30-33) dans un réseau d'électrodes (20) pour synthétiser une molécule, ledit système comprenant un réseau de cellules d'électrodes, chaque cellule d'électrode (60) comprenant:
i. un transistor d'accès (70) ayant
- une grille,
- une source, et
- un drain ; et
ii. un circuit de stockage (80) ;
**caractérisé en ce que**
- les électrodes sont des nanoélectrodes,
- le réseau d'électrodes est un réseau de nanoélectrodes,
- la grille est couplée résistivement à une ligne de mot (71),
- la source est couplée résistivement à une ligne de bit (72), et
- le circuit de stockage (80) est couplé résistivement au drain et comprend une nanoélectrode (30-33).

2. Le système selon la revendication 1, dans lequel le réseau de cellules d'électrodes (60) comprend
- une ou plusieurs rangées, les cellules d'électrodes (60) dans une rangée étant reliées par une ligne de mot commune (71), et/ou
- une ou plusieurs colonnes, les cellules d'électrodes (60) dans une colonne étant reliées par une ligne de bit commune (72).

3. Le système selon l'une quelconque des revendications précédentes, dans lequel le circuit de stockage (80) comprend la nanoélectrode (30-33) et une connexion électrique couplant résistivement la nanoélectrode (30-33) au drain.

4. Le système selon l'une quelconque des revendications précédentes, dans lequel le circuit de stockage (80) comprend en outre un condensateur (81).

5. Le système selon la revendication 4, dans lequel le condensateur (81) a une borne couplée résistivement à la fois au drain et à la nanoélectrode (30-33).

6. Le système selon l'une quelconque des revendications précédentes, dans lequel le circuit de stockage (80) a une capacité d'au moins 0,01 fF, de préférence d'au moins 1 fF, plus préférentiellement d'au moins 10 fF, encore plus préférentiellement d'au moins 25 fF.

7. Le système selon l'une quelconque des revendications précédentes, dans lequel le réseau de cellules d'électrodes compte 30 000 cellules d'électrodes (60) ou plus, de préférence 100 000 ou plus, plus préférentiellement 250 000 ou plus, encore plus préférentiellement 1 000 000 ou plus, et très préférentiellement 10 000 000 ou plus.

8. Le système selon l'une quelconque des revendications précédentes, dans lequel le transistor d'accès est un transistor de fin de ligne arrière (BEOL).

9. Le système selon l'une quelconque des revendications précédentes, dans lequel les nanoélectrodes ont un pas de 1 µm ou moins, de préférence 500 nm ou moins, plus préférentiellement 250 nm ou moins, encore plus préférentiellement 150 nm ou moins.

10. Utilisation d'un système tel que défini dans l'une quelconque des revendications précédentes, pour adresser des nanoélectrodes (30-33) dans un réseau de nanoélectrodes (20).

11. Un procédé pour adresser des nanoélectrodes (30-33) dans un système tel que défini dans l'une quelconque des revendications 1 à 8, comprenant :
a. sélectionner un potentiel pour chaque nanoélectrode (30-33), et
b. régler les potentiels sélectionnés en, pour chaque cellule d'électrode (60),
- ouvrant le transistor d'accès (70) en activant la ligne de mot (71) et
- chargeant le circuit de stockage (80) au potentiel d'électrode sélectionné en polarisant adéquatement la ligne de bit (72).

12. Le procédé selon la revendication 11, dans lequel l'étape b comprend le réglage simultané d'une pluralité de potentiels d'électrode sélectionnés en,
- pour une rangée de cellules d'électrodes (60) reliées par une ligne de mot commune (71), ouvrant tous les transistors d'accès (70) en activant la ligne de mot commune (71) et,
- pour chaque cellule d'électrode (60) dans la rangée, chargeant le circuit de stockage (80) en polarisant adéquatement la ligne de bit (72).

13. Le procédé selon l'une quelconque des revendications 11 à 12, comprenant une étape supplémentaire c de :
c. rafraîchir les potentiels sélectionnés en répétant l'étape b.

14. Un procédé pour synthétiser une molécule, comprenant :
a. régler le potentiel d'une ou plusieurs nanoélectrodes (30-33) en utilisant le procédé selon l'une quelconque des revendications 11 à 13, et
b. mettre en contact un ou plusieurs réactifs avec les nanoélectrodes (30-33) ;
générant ainsi localement des conditions de réaction pour faciliter la synthèse.

15. Le procédé selon la revendication 14, pour former un stockage de données ADN.
